# EUROPEAN PATENT SPECIFICATION

(11) **EP 1 528 847 B1**
(45) Date of publication and mention of the grant of the patent: **08.08.2007**
(21) Application number: 03425697.4
(22) Date of filing: 29.10.2003
(51) Int. Cl.: H05K 1/02, H05K 7/20, H01L 23/367

(54) **Heat dissipating insert, circuit comprising said insert and production method**
Wärmeableiteinsatz, Schaltung mit einem solchen Einsatz und Verfahren zur Herstellung
Insert dissipant la chaleur, circuit comprenant ledit insert et méthode de production

(43) Date of publication of application: 04.05.2005
(73) Proprietor: POWER ONE ITALY S.p.A., Terranuova Bracciolini (AR) (IT)
(72) Inventor: Matini, Simone, 50126 Firenze (IT)
(74) Representative: Mannucci, Michele

(56) References cited:
- EP-A- 0 741 504
- DE-U- 20 301 773
- US-A- 5 014 904

## Description

### Field of the invention

The present invention relates to an electronic circuit comprising a board with printed circuits and means for heat dissipation for its electronic components such as the power components, for example diodes and MOSFETs.

### Bckground of the invention

Electronic circuits on which components, hereinafter generically called "power components", that require measures for heat dissipation are mounted include elements in thermal contact with these power components having the function of conducting heat from inside the chip, where this heat develops, to an external device that facilitates dissipation.

Generally, the electronic power component is fixed to an element of the heat dissipator using suitable fixing means, such as elastic springs or thermally conductive adhesives.

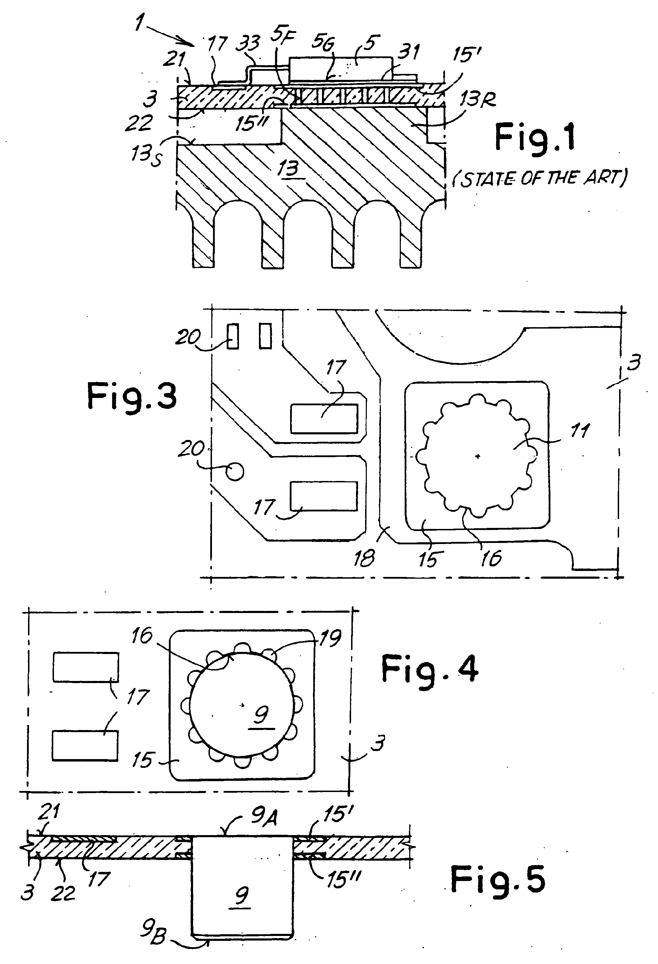

The electronic circuit in Figure 1 describes an exemplifying embodiment of the state of the art comprising an electronic board 1 with printed circuits - not shown in the Figure - on two upper and lower surfaces, 21 and 22 respectively, and a heat dissipation system for an electronic power component 5 fixed to the electronic board 1. The power component 5 is placed on an insulator 3 forming the support of the electronic board 1, so that the conductive pins 33 of the component 5 are soldered to respective contacts 17 of the printed circuit produced on the upper face 21 of the insulating support 3, and the area corresponding to the joint 5G of the component 5 is glued to a conductive pad 15' of this printed circuit. Sufficient dissipation of heat is guaranteed by a conductive adhesive used to form a layer 31 and metallized through-holes 5F that connect the pad 15' with a pad 15" of a printed circuit produced on the lower face 22 of the insulating support 3. This pad 15" comes into contact with a raised part 13R of a dissipator 13, to form the thermal connection between the power component and said dissipator. This raised part 13R of the dissipator 13 is necessary as it performs the function of moving the lower surface 13S of the dissipator away from contacts and solderings for electronic components produced on this face 22 of the insulating support 3. Normally, several power components 5, that is components requiring a thermal contact with a dissipator, are disposed on the same board. Their distribution varies from board to board, and the dimensions and forms of the various components may also vary. This leads to the need to design and produce a large number of dissipators 13, 13R, one for each type of circuit, resulting in high production costs. Costs are further increased by the fact that these dissipators must be produced by mechanical chip removal machining of thick plates, or by casting with forms of complex morphology.

An electronic circuit with a dissipative component according to the preamble of claim 1 is disclosed in DE-A-20301773 and in US-A-5014904.

### Objects and summary of the invention

Starting from DE-A-20301773, the object of the invention is to facilitate not only insertion of the heat dissipative insert, but also thermal contact and the actual soldering process.

This object is achieved with an electronic circuit according to claim 1 and with a method according to claim 22. In substance, according to the invention, heat conduction is guaranteed by a conductive dissipative insert inserted inside a through-hole produced in the insulating layer of the electronic board at the level of the pad on which the power component is mounted, said hole having undulations or serrations, which facilitate the insertion of the insert, and improve thermal contact and the actual soldering process, allowing the solder material to penetrate between the surface of the hole and the lateral surface of the dissipative insert. Among other things, this avoids the risk of the power component tending to "float" on the molten solder paste during the soldering phase.

This dissipative insert advantageously has flat and continuous heat exchange faces, a first of which in contact with the electronic power component and a second in contact with the heat dissipater; in this way the heat exchange surface increases with consequent improvement in the conduction of heat between power component and dissipator.

The first face of the insert is preferably flush with the surface of the electronic board on which the power component is mounted, the second face projects advantageously from the opposed surface of said board for a length that guarantees the distance of the dissipator from the surface of the board on which the contact solderings of the components and/or further electronic components are produced.

An electronic circuit that comprises boards with printed circuits according to the invention is therefore generally composed of a plurality of electronic components, some of which power components, and of a plurality of corresponding dissipative inserts. This plurality of dissipative inserts is advantageously characterized in that it projects by the same amount from the second surface of the electronic board, so that the respective second faces of the various inserts are aligned on the same plane. This makes it possible to use a heat dissipator in thermal contact with the inserts that advantageously has a flat and continuous surface in contact with the inserts, to allow simple and inexpensive production of said dissipator.

As electronic boards generally have standard dimensions, with the principle underlying the invention it is possible to produce a limited number of dissipators, for example equal to the number of boards of different dimensions employed. According to the layout of the individual electronic circuit, heat dissipation of the various power components is guaranteed by suitable distribution of the dissipative inserts at the level of the positions of the power components. A single dimension or a limited number of dimensions of the dissipative inserts may be used for power components that differ even greatly in forms and dimensions.

In an advantageous embodiment the dissipative insert is produced in a conductive material, such as copper, in order to connect the electronic component both thermally to the dissipator, and if necessary electrically to the pad of a printed circuit on the second surface of the board.

The insert may also be coated with a material that is easy to solder to the electronic circuit, such as nickel or tin, to facilitate soldering.

Advantageously, electrically insulating elements which are excellent heat conductors are provided on the face of the insert in contact with the heat dissipator, for example gap fillers, i.e. thin silicone rubber pads enriched with heat conducting materials, to obtain thermal conduction electrically insulating the dissipator.

In an further embodiment, an electronic circuit comprises boards with printed circuits with several layers produced inside the insulating support and dissipative inserts that electrically connect the respective electronic power components with at least one of these printed circuit layers.

In a further advantageous embodiment of the invention the heat dissipator is produced by the external container of said electronic board.

In fact, using the inserts according to the invention, it is not necessary always to provide an additional, specifically shaped dissipator, in thermal contact with the power components. The dissipative inserts may be in direct thermal contact (or with the interposition of thermally conductive electric insulators) with the housing of the electronic circuit.

The dissipative insert in the preferred embodiment has a cylindrical form with a circular section, or if needed a slightly conical form to facilitate insertion into the hole. It may be provided with apertures, for examples cuts or slots, to increase deformability and/or facilitate insertion, or to increase the heat exchange surface with the environment and be used directly as a heat dissipator, without being connected to an additional dissipation element. In the preferred embodiment, however, the dissipative insert will have a simple geometric form, especially a cylindrical form, to reduce production costs.

Electronic components may also be fixed to flat walls orthogonal to the electronic board applied to the dissipative inserts according to the invention, by means of traditional fixing systems such as elastic springs, or using a mounting system for horizontally positioned components. The dissipative inserts may therefore be in the form of a parallelepiped with a polygonal section, preferably square or rectangular, on at least one face of which a power component is advantageously fixed.

In the preferred embodiment this dissipative insert is soldered in the through-hole, although other methods may be used to fix it to the electronic board, such as coupling with interference, obtained by deforming the edge of the hole and/or the dissipative insert.

The invention also relates to a method to produce an electronic circuit comprising at least a power component and a corresponding dissipative insert.

Essentially, according to the method of the invention, a through-hole with a serrated edge is first produced on an electronic board, at the level of the pad of an electronic power component; the dissipative insert is then inserted so that a first of its faces is advantageously flush with the surface of the electronic board on which the single power component is mounted, while the second face projects from the opposed surface of the electronic board. Subsequently the power component is applied, in thermal contact with the dissipative insert.

In a preferred embodiment of the method according to the invention, after having inserted the dissipative insert in the respective hole, a solder paste is applied to the pad and to the first face of the insert - by silk-screening or any other known method. The power component is subsequently placed on the solder paste and its contact pins are positioned on the specific contacts of the electronic board to which the solder paste was applied with the same silk-screening or other known system. The operation described above is in practice performed for all the power components of the circuit. After having also applied (in a per se known way) the other logic components, that is those that do not require thermal contact with a heat sink, the board is placed in the oven for reflow soldering. Heating causes the solder paste to melt. At the holes in which the dissipative inserts are fixed the serrations on the edge of the hole allow increased infiltration of the solder paste on the contact surfaces between the hole and the insert.

Finally, after having soldered the components of the board, if necessary a heat dissipator with a flat face in thermal contact with the second face of each dissipative insert is fixed to the board, electrically insulating said dissipator by applying electric insulating means and heat conductors to the areas of thermal contact.

Mounting of the dissipative inserts and of the various power and logic components may be performed using SMD technology.

The various components may also be soldered with other known systems.

### Brief description of the figures

The present invention may be better understood and its numerous objects and advantages will be more apparent to those skilled in the art by reading the description hereunder with reference to the accompanying schematic drawings, which show a non-limiting practical example of the invention. In the drawing:
Figure 1 shows, in a section according to a plane orthogonal to the electronic board, the area of an electronic circuit where a power component is mounted according to an exemplifying embodiment of the state of the art;
Figure 2 shows, in a section orthogonal to the electronic board, an electronic circuit according to the invention;
Figure 3 shows the top view of a hole produced in an electronic board according to the invention;
Figure 4 shows the top view of a dissipative insert inserted in the hole in Figure 3;
Figure 5 shows a section orthogonal to the electronic board of the area of the circuit wherein the power component in Figure 2 is mounted;
Figure 6 shows an enlargement of the area VI of the electronic circuit in Figure 2.

### Detailed description of the preferred embodiments of the invention

In the drawings, wherein equal numbers correspond to equal parts in all the different figures, an electronic circuit comprises a board with printed circuits according to the present invention indicated generically with 10, see Figure 2.

The electronic board 10 is constituted by an electrically insulated support 3, on the upper surface 21 of which conductive tracks 18 are produced, see Figure 3, forming a printed circuit, that electrically connect a plurality of electronic logic components 7 and electronic power components 5. The printed circuit with the conductive tracks 18 is produced in a way per se known and not described herein. The components herein denominated "logic components" are all those components that do not require thermal contact with a heat dissipator. The components herein denominated "power components" are in general those that require thermal contact with a heat dissipator, that is with a heat sink.

According to the invention, the electronic power components 5 are in contact with dissipative inserts 9 inserted in through-holes 11 produced in the electronic board 10. These dissipative inserts 9 are, moreover, in contact with a heat dissipator 13 at a distance from the opposed surface 23 of the electronic board 10.

The through-holes 11 are advantageously provided with serrations 16, see Figure 3, and produced in the conductive pad 15' of the printed circuit on which a power component 5 is positioned. Electric contacts 17 of the printed circuit 18 for pins 33 of a power component 5 are produced at a distance from the pad 15'.

Figure 4 shows a dissipative insert 9 with a circular section inserted in the through-hole 11 in Figure 3. The external surface of said insert 9 defines with the serrations 16 a series of through apertures 19 suitable to improve insertion of the insert and drainage of the solder paste from the upper face 21 to the lower face 22 during soldering.

Figure 5 shows a vertical section of the area of the circuit according to the embodiment described comprising: on the face 21 of the insulating support 3 the conducting pad 15 for subsequent positioning of the power component 5, the contacts 17 for the pins of the component 5 and a conducting pad 15" of a printed circuit - not shown in the Figures - on the lower face 22. After having inserted the dissipative insert 9 in the hole 11, a solder paste is applied (with a silkscreen procedure or any another suitable way) to the upper surface 9A of the insert and on the pad 15'. This operation is performed for all the inserts 9 inserted in the board and analogously the solder paste is also applied on the connecting pads 17 for the pins of the power component, and on other pads of the electronic board on which the other electronic components are to be soldered. Subsequently, with an SMD mounting technique or in another suitable way, the various electronic logic (7) and power (5) components are applied to the board.

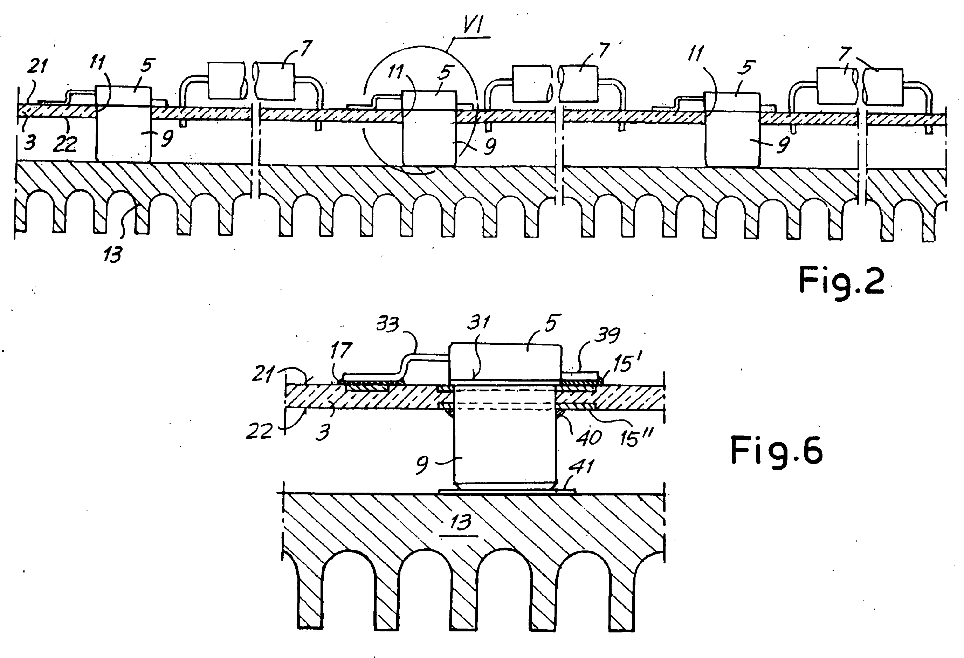

Figure 6 shows a section of a detail of the area of the circuit relative to the invention: the electronic power component 5 is positioned on a layer 31 of solder paste applied to the conducting pad 15' produced as in Figure 5. The solder paste has also been applied in 35 and 37 to solder the leads 33 and 39 of the power component 5 to the contacts 17 and the conducting pad 15' respectively.

The solder paste is then melted by placing the circuit in the oven. The solder paste applied to the dissipative insert 9 melts to penetrate through the apertures 19 (Figure 4) and reaches the face of the board opposed to the one on which the component 5 is applied, forming a solder area 40.

Advantageously, between the lower face 9B of the insert 9 and a dissipator 13 applied in thermal contact with it an electrically insulating and thermally conductive layer 41 is interposed, to electrically insulate the electronic components in respect of the dissipator 13 and allow heat conduction between these components and said dissipator 13. Contrary to the dissipator 13 in Figure 1, the dissipator 13 has a flat contact surface with all the dissipative inserts 9 in the electronic circuit, as can be seen in particular in Figure 2. It may thereby be produced with noteworthy savings on costs in respect of the dissipator 13 in Figure 1. Moreover, it is unnecessary to provide different dissipators, dedicated to the single circuits.

As the dissipative inserts 9 are essentially all aligned at the same level, that is all essentially projecting by the same amount from the lower surface of the electronic board, the circuit may also be placed directly in thermal contact, by means of the surfaces 9B of the inserts 9, with a thermally conductive container wherein the circuit is housed. Also in this case electrically insulating and thermally conductive layers or strips may be provided between the surfaces 9A of the inserts 9 and the surface of the container with which said inserts are brought into thermal contact.

It is understood that the above represents purely a non-limiting possible embodiment of the invention, which may vary in forms and layouts, without however departing from the scope of the concept underlying the invention. Any reference numbers in the appended claims are provided purely to facilitate reading in the light of the description hereinbefore and of the accompanying drawings and do not limit the scope of protection whatsoever.

## Claims

1. An electronic circuit comprising a board (10) with printed circuits; at least an electronic power component (5) mounted on a first surface (21) of said board (10) and a system to dissipate heat produced by said electronic power component, wherein said system to dissipate heat comprises at least a thermally conductive dissipative insert (9) inserted inside a through-hole (11) produced in said board at the level of said electronic power component (5), with a first face (9A) in thermal contact with said electronic power component (5) mounted on said first surface (21), and projecting from the opposed surface of said board; **characterized in that** said through-hole (11) in which said dissipative insert (9) is inserted has an edge that is undulated or provided with serrations (16).

2. Electronic circuit as claimed in claim 1, **characterized in that** said at least one dissipative insert (9) is electrically conductive and electrically connects pads (15', 15") on two opposed faces (21, 22) of the electronic board (10).

3. Circuit as claimed in claim 1 or 2, **characterized in that** said dissipative insert (9) electrically connects the power component (5) to at least one of the printed circuit layers of which said circuit is formed.

4. Electronic circuit as claimed in claim 1, 2 or 3, **characterized in that** said at least one dissipative insert (9) is placed with the first face (9A) essentially flush with the first surface (21) of the board (10), on which said electronic power component is mounted.

5. Electronic circuit as claimed in one or more of the previous claims, **characterized in that** said first face (9A) is flat and continuous.

6. Electronic circuit as claimed in one or more of the previous claims, **characterized in that** said at least one dissipative insert (9) comprises a second flat and continuous surface (9B), in thermal contact with a heat dissipating element (13).

7. Circuit as claimed in one or more of the previous claims, **characterized in that** said through-hole (11) is provided in a pad (15') of said electronic board (10) on which said power component (5) is positioned.

8. Circuit as claimed in one or more of the previous claims, **characterized in that** said at least one dissipative insert (9) is soldered in said through-hole (11).

9. Circuit as claimed in claim 6, **characterized in that** said dissipative insert (9) is soldered together with said power component (5) and in electrical contact with it.

10. Circuit as claimed in one or more of the previous claims, **characterized in that** the coupling between said dissipative insert (9) and said through-hole (11) is a coupling with interference, obtained by deforming the edge of the hole or of the dissipative insert.

11. Circuit as claimed in one or more of the previous claims, **characterized in that** it comprises a plurality of power components and a plurality of corresponding dissipative inserts.

12. Circuit as claimed in claim 11, **characterized in that** said dissipative inserts all project for substantially the same amount from the second surface of the electronic board and the respective faces (9B) opposed to the face (9A) in thermal contact with the power components are essentially aligned on a plane.

13. Circuit as claimed in claim 12, **characterized in that** it comprises a heat dissipating element (13) with a flat surface in thermal contact with said dissipative inserts.

14. Circuit as claimed in at least claim 6, **characterized in that** a thermally conductive electric insulation (41) is disposed between said at least one dissipative insert (9) and said heat dissipating element (13).

15. Circuit as claimed in claim 14, **characterized in that** said electric insulation comprises a thin strip (41) of silicone rubber enriched with heat conducting material.

16. Circuit as claimed in at least claim 13, **characterized in that** said heat dissipating element (13) is produced directly on a surface of the container of said electronic board (10).

17. Circuit as claimed in one or more of the previous claims, **characterized in that** said at least one dissipative insert (9) has a cylindrical form.

18. Circuit as claimed in claim 17, **characterized in that** said at least one dissipative insert (9) has a conical form.

19. Circuit as claimed in claim 17 or 18, **characterized in that** said dissipative insert (9) has a circular section.

20. Circuit as claimed in one or more of the previous claims, **characterized in that** said at least one dissipative insert (9) is produced in copper.

21. Circuit as claimed in one or more of the previous claims, **characterized in that** said at least one dissipative insert (9) is coated in a solderable electrically conductive material, such as nickel and/or tin.

22. A method for producing an electronic circuit comprising an electronic board (10), at least one electronic power component (5) mounted on a first surface (21) of said board (10) and a system to dissipate the heat produced by said electronic power component (5), **characterized by** the steps of:
➢ producing a through-hole (11) in said board, at the level of said electronic power component (5);
➢ inserting and blocking in said hole (11) a thermally conductive dissipative insert (9), so that it projects from a second surface (22) of said board (10) opposed to said first surface (21);
➢ mounting on said first surface (21) of said board (10) said power component (5), in thermal contact with a first face of said dissipative insert (9);
**characterized in that** said through hole (11) is produced with an undulated or serrated edge (16).

23. Method as claimed in claim 22, **characterized in that** said through-hole (11) is produced at the level of a soldering pad (15') of the electronic power component (5).

24. Method as claimed in claim 22 or 23, **characterized in that** said dissipative insert (9) is placed with its first face (29) flush with the first surface (21) of the board (10), said first face being essentially flat.

25. Method as claimed in one or more of claims 22 to 24, **characterized in that** a solder paste is applied to said first surface (21) of the board (10) at the level of said hole (11) and said electronic power component (5) and said dissipative insert (9) are soldered by means of said solder paste to the board (10).

26. Method as claimed in claim 25, **characterized by** the steps of:
- producing said through-hole;
- inserting said dissipative insert (9) into said hole (11), with its first face (9A) flush with the first surface (21) of the electronic board (10);
- applying a thin layer of solder paste (31) to said pad (15');
- positioning said electronic component (5) on said pad (15');
- soldering said dissipative insert (9) and said electronic power component (5) to said board (10)

## Patentansprüche

1. Elektronische Schaltung umfassend eine Platine (10) mit gedruckten Schaltungen; mindestens eine elektronische Leistungskomponente (5), die auf einer ersten Oberfläche (21) der Platine (10) montiert ist, und ein System zum Ableiten der von der elektronischen Leistungskomponente erzeugten Wärme, wobei das System zur Wärmeableitung mindestens einen thermisch leitfähigen Ableiteinsatz (9) aufweist, der in ein in der Platine in Höhe der elektronischen Leistungskomponente (5) ausgebildetes, durchgehendes Loch (11) eingesetzt ist, wobei es mit einer ersten Fläche (9A) in thermischem Kontakt mit der auf der ersten Oberfläche (21) montierten elektronischen Leistungskomponente (5) steht und über die entgegengesetzte Oberfläche der Platine vorsteht, **dadurch gekennzeichnet, dass** das durchgehende Loch (11), in welches der Ableiteinsatz (9) eingesetzt ist, einen Rand aufweist, der gewellt oder mit Kerben (16) versehen ist.

2. Elektronische Schaltung nach Anspruch 1, **dadurch gekennzeichnet, dass** der mindestens eine Ableiteinsatz (9) elektrisch leitfähig ist und Anschlussflächen (15', 12") (pads) auf zwei entgegengesetzten Flächen (21, 22) der elektronischen Platine (10) elektrisch miteinander verbindet.

3. Schaltung nach Anspruch 1 oder 2, **dadurch gekennzeichnet, dass** der Ableiteinsatz (9) die Leistungskomponente (5) mit mindestens einer der gedruckten Schaltungsschichten, aus denen die Schaltung gebildet ist, elektrisch verbindet.

4. Elektronische Schaltung nach Anspruch 1, 2 oder 3, **dadurch gekennzeichnet, dass** der mindestens eine Ableiteinsatz (9) so platziert ist, dass die erste Fläche (9A) im Wesentlichen bündig mit der ersten Oberfläche (21) der Platine (10) ist, auf der die elektronische Leistungskomponente montiert ist.

5. Elektronische Schaltung nach einem oder mehreren der vorangehenden Ansprüche,
**dadurch gekennzeichnet, dass** die erste Fläche (9A) flach und durchgehend ist.

6. Elektronische Schaltung nach einem oder mehreren der vorangehenden Ansprüche, **dadurch gekennzeichnet, dass** der mindestens eine Ableiteinsatz (9) eine zweite flache und durchgehende Fläche (9B) aufweist, die in thermischen Kontakt mit einem Wärmeableitelement (13) ist.

7. Schaltung nach einem oder mehreren der vorangehenden Ansprüche, **dadurch gekennzeichnet, dass** das durchgehende Loch (11) in einer Anschlussfläche (pad) (15') der elektronischen Platine (10), auf der die Leistungskomponente (5) angeordnet ist, vorgesehen ist.

8. Schaltung nach einer oder mehreren der vorangehenden Ansprüche, **dadurch gekennzeichnet, dass** der mindestens eine Ableiteinsatz (9) in dem durchgehenden Loch (11) verlötet ist.

9. Schaltung nach Anspruch 6, **dadurch gekennzeichnet, dass** der Ableiteinsatz mit der Leistungskomponente (5) verlötet und in elektrischen Kontakt mit ihr ist.

10. Schaltung nach einem oder mehreren der vorangehenden Ansprüche, **dadurch gekennzeichnet, dass** die Kopplung zwischen dem Ableiteinsatz (9) und dem durchgehenden Loch (11) eine Kopplung mit Presssitz ist, die durch Verformung des Randes des Lochs oder des Ableiteinsatzes erhalten wurde.

11. Schaltung nach einem oder mehreren der vorangehenden Ansprüche, **dadurch gekennzeichnet, dass** sie eine Mehrzahl von Leistungskomponenten und eine Mehrzahl von entsprechenden Ableiteinsätzen aufweist.

12. Schaltung nach Anspruch 11, **dadurch gekennzeichnet, dass** alle Ableiteinsätze im Wesentlichen um denselben Betrag über die zweite Oberfläche der elektronischen Platine vorstehen und die der Fläche (9A) entgegengesetzten jeweiligen Flächen (9B), die in thermischen Kontakt mit den Leistungskomponenten sind, im Wesentlichen im einer Ebene ausgerichtet sind.

13. Schaltung nach Anspruch 12, **dadurch gekennzeichnet, dass** sie ein wärmeableitendes Element (13) mit einer flachen Oberfläche aufweist, die in thermischen Kontakt mit den Ableiteinsätzen ist.

14. Schaltung mindestens nach Anspruch 6, **dadurch gekennzeichnet, dass** eine thermisch leitfähige elektrische Isolierung (41) zwischen dem mindestens einen Ableiteinsatz (9) und dem wärmeableitenden Element (13) angeordnet ist.

15. Schaltung nach Anspruch 14, **dadurch gekennzeichnet, dass** die elektrische Isolierung einen dünnen Streifen (41) aus Silikongummi, das mit wärmeleitfähigem Material angereichert ist, aufweist.

16. Schaltung mindestens nach Anspruch 13, **dadurch gekennzeichnet, dass** das wärmeableitende Element (13) direkt an einer Oberfläche des Behälters der elektronischen Platine (10) erzeugt ist.

17. Schaltung nach einem oder mehreren der vorangehenden Ansprüche, **dadurch gekennzeichnet, dass** der mindestens eine Ableiteinsatz (9) eine zylindrische Form hat.

18. Schaltung nach Anspruch 17, **dadurch gekennzeichnet, dass** der mindestens eine Ableiteinsatz (9) eine konische Form hat.

19. Schaltung nach Anspruch 17 oder 18, **dadurch gekennzeichnet, dass** der Ableiteinsatz (9) einen runden Querschnitt hat.

20. Schaltung nach einem oder mehreren der vorangehenden Ansprüche, **dadurch gekennzeichnet, dass** der mindestens eine Ableiteinsatz (9) aus Kupfer besteht.

21. Schaltung nach einem oder mehreren der vorangehenden Ansprüche, **dadurch gekennzeichnet, dass** der mindestens eine Ableiteinsatz (9) mit einem lötfähigen, elektrisch leitfähigen Material, wie Nickel und/oder Zinn, überzogen ist.

22. Verfahren zur Herstellung einer elektronischen Schaltung mit einer elektronischen Platine (10), mindestens einer elektronischen Leistungskomponente (5), die auf einer ersten Oberfläche (21) der Platine (10) montiert ist, und einem System zum Ableiten von Wärme, die von der elektrischen Leistungskomponente (5) erzeugt wird, **gekennzeichnet durch** die Schritte:
➢ Erzeugen eines durchgehenden Lochs (11) in der Platine in Höhe der elektronischen Leistungskomponente (5);
➢ Einführen und Blockieren eines thermisch leitfähigen Ableiteinsatzes (9) in dem Loch (11) derart, dass dieser über eine zweite Oberfläche (22) der Platine (10), die der ersten Oberfläche (21) entgegengesetzt ist, übersteht;
➢ Montieren der Leistungskomponente (5) auf der ersten Oberfläche (21) der Platine (10) in thermischen Kontakt mit einer ersten Fläche des Ableiteinsatzes (9);
**dadurch gekennzeichnet, dass** das durchgehende Loch (11) mit einem gewellten oder gezähnten Rand (16) ausgebildet wird.

23. Verfahren nach Anspruch 22, **dadurch gekennzeichnet, dass** das durchgehende Loch (11) im Bereich einer Lötfläche (15') der elektronischen Leistungskomponente (5) ausgebildet wird.

24. Verfahren nach Anspruch 22 oder 23, **dadurch gekennzeichnet, dass** der Ableiteinsatz (9) so platziert wird, dass seine erste Fläche (29) bündig mit der ersten Oberfläche (21) der Platine (10) liegt, wobei die erste Fläche im Wesentlichen flach ist.

25. Verfahren nach einem oder mehreren der Ansprüche 22 bis 24, **dadurch gekennzeichnet, dass** eine Lötpaste auf der ersten Oberfläche (21) der Platine (10) im Bereich des Lochs (11) und der elektronischen Leistungskomponente (5) aufgebracht wird und der Ableiteinsatz (9) mittels der Lötpaste mit der Platine (10) verlötet wird.

26. Verfahren nach Anspruch 25, **gekennzeichnet durch** die Schritte:
- Erzeugen des durchgehenden Lochs;
- Einführen des Ableiteinsatzes (9) in das Loch (11) derart, dass seine erste Fläche (9A) bündig mit der ersten Oberfläche (21) der elektronischen Platine (10) liegt;
- Aufbringen einer dünnen Schicht aus Lötpaste (31) auf die Anschlussfläche (15');
- Positionieren der elektronischen Komponente (5) auf der Anschlussfläche (15');
- Verlöten des Ableiteinsatzes (9) und der elektronischen Leistungskomponente (5) mit der Platine (10).

## Revendications

1. Circuit électronique comprenant une plaque (10) avec circuits imprimés, au moins un composant de puissance électronique (5) monté sur une première surface (21) de ladite plaque (10) et un système pour dissiper de la chaleur produite par ledit composant de puissance électronique, dans lequel ledit système pour dissiper de la chaleur comprend au moins un insert de dissipation thermo-conducteur (9) inséré à l'intérieur d'un orifice de passage (11) créé dans ladite plaque au niveau dudit composant de puissance électronique (5), avec une première face (9A) en contact thermique avec ledit composant de puissance électronique (5) monté sur ladite première surface (21), et débordant de la surface opposée de ladite plaque, **caractérisé en ce que** ledit orifice de passage (11) dans lequel est inséré ledit insert de dissipation (9) a un bord ondulé ou équipé de dentelures (16).

2. Circuit électronique selon la revendication 1, **caractérisé en ce que** ledit moins un insert de dissipation (9) est électriquement conducteur et connecte électriquement des pastilles (15', 15") sur deux faces opposées (21, 22) de la plaque électronique (10).

3. Circuit selon les revendications 1 ou 2, **caractérisé en ce que** ledit insert de dissipation (9) connecte électriquement le composant de puissance (5) à au moins une des couches de circuit imprimé dont est formé ledit circuit.

4. Circuit électronique selon les revendications 1, 2 ou 3, **caractérisé en ce que** ledit au moins un insert de dissipation (9) est placé avec la première face (9A) essentiellement en contact avec la première surface (21) de la plaque (10) sur laquelle est monté ledit composant de puissance électronique.

5. Circuit électronique selon une ou plusieurs des revendications précédentes, **caractérisé en ce que** ladite première face (9A) est plate et continue.

6. Circuit électronique selon une ou plusieurs des revendications précédentes, **caractérisé en ce que** ledit au moins un insert de dissipation (9) comprend une deuxième surface plate et continue (9B) en contact thermique avec un élément de dissipation de chaleur (13).

7. Circuit selon une ou plusieurs des revendications précédentes, **caractérisé en ce que** ledit orifice de passage (11) est équipé d'une pastille (15') de ladite plaque électronique (10) sur laquelle est positionné ledit composant de puissance (5).

8. Circuit selon une ou plusieurs des revendications précédentes, **caractérisé en ce que** au moins un insert de dissipation (9) est soudé dans ledit orifice de passage (11).

9. Circuit selon la revendication 6, **caractérisé en ce que** ledit insert de dissipation (9) est soudé avec ledit composant de puissance (5) et est en contact électrique avec elle.

10. Circuit selon une ou plusieurs des revendications précédentes, **caractérisé en ce que** le couplage entre ledit insert de dissipation (9) et ledit orifice de passage (11) est un couplage à interférence, obtenu par déformation du bord de l'orifice ou de l'insert de dissipation.

11. Circuit selon une ou plusieurs des revendications précédentes, **caractérisé en ce qu'**il comprend une pluralité de composants de puisance et une pluralité d'inserts de dissipation correspondants.

12. Circuit selon la revendication 11, **caractérisé en ce que** les dits inserts de dissipation débordent tous de sensiblement la même quantité de la deuxième surface de la plaque électronique et les faces respectives (9B) opposées à la face (9A) en contact thermique avec les composants de puissance sont essentiellement alignées sur un plan.

13. Circuit selon la revendication 12, **caractérisé en ce qu'**il comprend un élément de dissipation de chaleur (13) avec une surface plate en contact thermique avec lesdits inserts de dissipation.

14. Circuit selon au moins la revendication 6, **caractérisé en ce qu'**une isolation électrique thermo-conductrice (41) est agencée entre au moins ledit au moins un insert de dissipation (9) et ledit élément de dissipation de chaleur (13).

15. Circuit selon la revendication 14, **caractérisé en ce que** ladite isolation électrique comprend une mince bande (41) de caoutchouc de silicone enrichi de matériau thermo-conducteur.

16. Circuit selon au moins la revendication 13, **caractérisé en ce que** ledit élément de dissipation de chaleur (13) est produit directement sur une surface du conteneur de ladite plaque électronique (10).

17. Circuit selon une ou plusieurs des revendications précédentes, **caractérisé en ce que** au moins un insert de dissipation (9) a une forme cylindrique.

18. Circuit selon la revendication 17, **caractérisé en ce que** ledit au moins un insert de dissipation (9) a une forme conique.

19. Circuit selon les revendications 17 ou 18, **caractérisé en ce que** ledit insert de dissipation (9) a une section circulaire.

20. Circuit selon une ou plusieurs des revendications précédentes, **caractérisé en ce que** ledit au moins un insert de dissipation (9) est en cuivre.

21. Circuit selon une ou plusieurs des revendications précédentes, **caractérisé en ce que** ledit au moins un insert de dissipation (9) est revêtu d'un matériau électroconducteur soudable, comme le nickel et/ou l'étain.

22. Procédé de production d'un circuit électronique comprenant une plaque électronique (10), au moins un composant de puissance électronique (5) monté sur une première surface (21) de ladite plaque (10) et un système pour dissiper de la chaleur produite par ledit composant de puissance électronique (5) **caractérisé par** les étapes suivantes :
➢ création d'un orifice de passage (11) dans ladite plaque, au niveau dudit composant de puissance électronique (5) ;
➢ insertion et blocage dans ledit orifice (11) d'un insert de dissipation thermo-conducteur (9) de manière à ce qu'il déborde d'une deuxième surface (22) de ladite plaque (10) opposée à ladite première surface (21) ;
➢ montage sur ladite première surface (21) de ladite plaque (10) dudit composant de puissance (5) en contact thermique avec une première face dudit insert de dissipation (9) ;
**caractérisée en ce que** ledit orifice de passage (11) a un bord ondulé ou dentelé (16).

23. Procédé selon la revendication 22, **caractérisé en ce que** ledit orifice de passage (11) est fabriqué au niveau d'une pastille de soudage (15') du composant de puissance électronique (5).

24. Procédé selon les revendications 22 ou 23, **caractérisé en ce que** ledit insert de dissipation (9) est placé avec sa première face (29) en contact avec la première surface (21) de la plaque (10), ladite première face étant essentiellement plate.

25. Procédé selon une ou plusieurs des revendications 22 à 24, **caractérisé en ce qu'**une pâte à souder est appliquée sur ladite première surface (21) de la plaque (10) au niveau dudit orifice (11) et ledit composant de puissance électronique (5) et ledit insert de dissipation (9) sont soudés à la plaque par ladite pâte de soudage (10).

26. Procédé selon la revendication 25, **caractérisé par** les étapes suivantes :
- création dudit orifice de passage ;
- insertion dudit insert de dissipation (9) dans ledit orifice (11) avec sa première face (9A) en contact avec la première surface (21) de la plaque électronique (10) ;
- application d'une mince couche de pâte de soudage (31) sur ladite pastille (15') ;
- positionnement dudit composant électronique (5) sur ladite pastille (15') ;
- soudage dudit insert de dissipation (9) et dudit composant de puissance électronique (5) sur ladite plaque (10).
